# EUROPEAN PATENT SPECIFICATION

(11) **EP 2 096 445 B1**
(45) Date of publication and mention of the grant of the patent: **25.06.2014**
(21) Application number: 07831511.6
(22) Date of filing: 09.11.2007
(51) Int. Cl.: B81C 3/00, G01N 35/08, G01N 37/00, B01J 19/00, B29C 65/00, B29C 65/14, B01L 3/00

(54) **MICROCHIP SUBSTRATE BONDING METHOD AND MICROCHIP**
MIKROCHIP-SUBSTRAT-BINDUNGSVERFAHREN UND MIKROCHIP
PROCÉDÉ DE LIAISON D'UN SUBSTRAT DE MICROPUCE ET MICROPUCE

(30) Priority: 01.12.2006 JP 2006325828
(43) Date of publication of application: 02.09.2009
(73) Proprietor: Konica Minolta Opto, Inc., Hachioji-shi, Tokyo 192-8505 (JP)
(72) Inventor: HIRAYAMA, Hiroshi, Hachioji-shi Tokyo 192-8505 (JP)
(74) Representative: Henkel, Breuer & Partner
(86) International application number: PCT/JP2007/071780
(87) International publication number: WO 2008/065868

(56) References cited:
- JP-A- 2001 305 050
- JP-A- 2002 055 098
- JP-A- 2004 138 411
- JP-A- 2005 305 234
- JP-A- 2006 187 730
- NAKANISHI H ET AL: "Studies on SiO2-SiO2 bonding with hydrofluoric acid-room temperature and low stress bonding technique for MEMS", MICRO ELECTRO MECHANICAL SYSTEMS, 1998. MEMS 98. PROCEEDINGS., THE ELE VENTH ANNUAL INTERNATIONAL WORKSHOP ON HEIDELBERG, GERMANY 25-29 JAN. 1998, NEW YORK, NY, USA,IEEE, US, 25 January 1998 (1998-01-25), pages 609-614, XP010270211, DOI: 10.1109/MEMSYS.1998.659827 ISBN: 978-0-7803-4412-9

## Description

### FIELD OF THE INVENTION

The present invention relates to an adhesion method of a microchip substrates on which a channel groove has been formed, and a microchip which is produced via the aforesaid method.

### BACKGROUND OF THE INVENTION

Micro analysis chips or devices called µTAS (Micro Total Analysis Systems) has been commercially available, in which minute channels and circuits are formed on a silicon or glass substrate, and in a minute space, liquid samples such as nucleic acid, protein or blood undergo chemical reaction, separation and analysis. Advantages of the aforesaid microchip are that the used amount of samples and reagents, as well as the discharged amount of effluent are reduced, whereby it is assumed that a space-saving, portable and low cost system is realized.

A microchip is produced via adhesion of two members, in which at least one of the members has undergone micro-fabrication. Heretofore, in the microchip, a glass substrate has been employed and various micro-fabrication methods have been proposed. However, since the glass substrate is unsuitable for mass production, and its cost is very high, development of a less expensive portable resin microchip has been sought.

Further, in an element, such as the aforesaid microchip, in which tests are conducted via flowing liquid through minute channels, a treatment to provide hydrophilicity to the channel surface is carried out so that a liquid sample such as protein does not adhere to the channel.

Processes to provide hydrophilicity to the channel surface include organic compound/inorganic compound coating, a plasma process, and a surface modifying method in which a solution is allowed to flow through the channel. Of these, SiO₂ film coating results in sufficient hydrophilicity and also exhibits features such as high stability because it is a material composed of an inorganic compound, and high transparency.

Further, methods to allow a microchip to adhere the substrates include: a method in which adhesion is carried out by employing an adhesive, a method in which adhesion is carried out by dissolving the surface of a resin substrate using an organic solvent (for example, Patent Document 1), a method in which adhesion is carried out by utilizing ultrasonic welding (for example, Patent Document 2), a method in which adhesion is carried out by utilizing heat welding (for example, Patent Document 3), and a method which utilizes laser welding (for example, Patent Document 4).
Patent Document 1: Japanese Patent Application Publication Open to Public Inspection (hereinafter referred to as JP-A) No. 2005-80569
Patent Document 2: JP-A No. 2005-77239
Patent Document 3: JP-A No. 2005-771218
Patent Document 4: JP-A No. 2005-74796

JP 2002 055098 A teaches a method wherein a resin member having a channel groove is adhered to a second resin member in order to form a fluidic duct. The same document also teaches that a coating of Si02 should be applied in order to improve wettability of the duct.

### SUMMARY OF THE INVENTION

### PROBLEM TO BE SOLVED BY THE INVENTION

When no hydrophilic film is formed on a microchip substrate, it is possible to allow resin microchip substrates to adhere to each other via the aforesaid methods. Further, in any of the ultrasonic welding, the heat welding, and the laser welding, resin microchip substrates are allowed to adhere to each other by fusing the resin surface of the substrate, followed by its solidification. As a result, when a hydrophilic film is formed on the interior surface of the minute channel groove and a hydrophilic film is also formed on the adhesion surface, it becomes difficult to allow microchip substrates to adhere to each other.

Specifically, when an inorganic SiO₂ film is utilized as a hydrophilic film, the aforesaid SiO₂ film is also formed on the adhesion interface between the microchip substrates, so that it has become common that adhesive agents are employed to allow microchip substrates to adhere to each other.

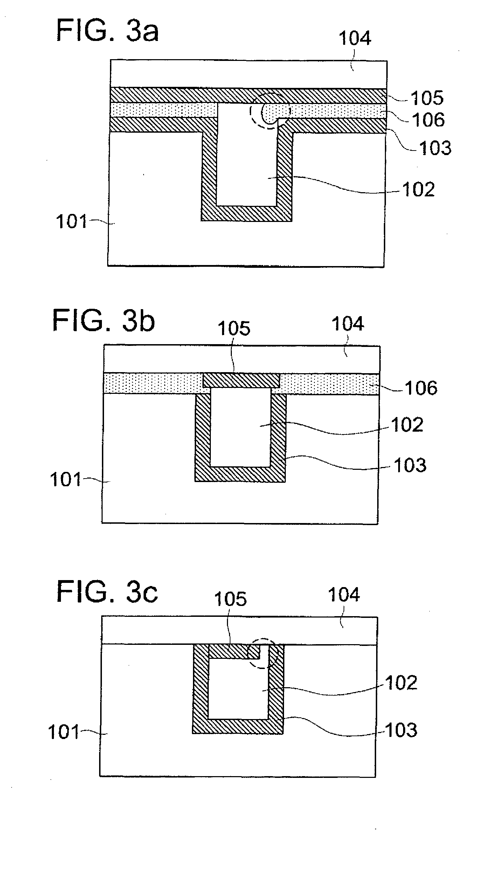

However, when microchip substrates are allowed to adhere to each other by employing adhesive agents, problems, shown in FIGS. 3a-3c, may occur. FIGS. 3a-3c are cross-sectional views to illustrate the adhesion method of microchip substrates according to conventional technologies. For instance, as shown in FIG. 3a, SiO₂ film 103 is formed on microchip 101 having thereon minute channel 102. At that time, SiO₂ film 103 is formed not only on the interior surface of minute channel 102 but also on the surface (being the adhesion surface) which adheres to another substrate. Further, the following cases may be considered: in order to cover minute channel 102, SiO₂ film 105 is formed on plate-like microchip substrate 104, followed by adhesion of both substrates via adhesive agent 106. As mentioned above, when both substrates are subjected to adhesion via adhesive agent 106, it is possible that, as shown by the broken line circle, minute channel 102 is blocked in such a manner that adhesive agent 106 exudes into the interior of minute channel 102. Further, since the major component of adhesive agent 106 after curing is a resin exhibiting hydrophobicity, it is possible that the hydrophilic function due to the SiO₂ film may deteriorate.

Further, another case may be considered in which, as shown in FIG. 3b, SiO₂ film 103 is formed only on the interior surface of minute channel 102, and in microchip substrate 104, SiO₂ film 105 is formed in the position corresponding to aforesaid minute channel 102 so that these substrates are allowed to adhere to each other via adhesive agent 106. However, in such a case, since adhesive agent 106 is thicker than SiO₂ film 105, it is possible that adhesive agent 106 exudes into the interior of minute channel 102.

Further, yet another case may be considered in which, as shown in FIG. 3c, an SiO₂ film is formed only on the interior surface of minute channel 102, and on microchip substrate 104, SiO₂ film 105 is formed in the position corresponding to aforesaid minute channel 102 so that these substrates are allowed to adhere to each other via heat welding, laser welding, or ultrasonic welding. However, in such a case, SiO₂ film patterning is required on both microchip substrate 101 and microchip substrate 104. In addition, when the film forming position of SiO₂ film 105 to microchip substrate 104 is not accurately determined, as shown by the broken line circle, the surface (being the resin) of microchip substrate 104 is exposed to minute channel 102, whereby it becomes impossible to cover minute channel 102 only by the SiO₂ film, exhibiting a hydrophilic function. As a result, it is possible that the hydrophilic function in minute channel 102 is not maintained.

As mentioned above, when adhesive agents are employed, a problem occurs in which the aforesaid adhesive agents protrude into the interior of the minute channel. Further, in the case when no adhesive agents is used, it is necessary to accurately determine the film forming position of the SiO₂ film, whereby a problem occurs in which the position adjustment is difficult. In any of the methods, a problem occurs in which it is difficult to ensure the hydrophilic function due to the SiO₂ film. Further, conventional methods are not suitable for mass production in view of cost.

The present invention is one to overcome the above problems. An object of the present invention is to provide an adhesion method capable of producing a microchip in such a manner that a hydrophilic film is formed on the interior surface of a minute channel and microchip substrates are allowed to adhere to each other without adhesive agents, and to provide the aforesaid microchip.

### MEANS TO SOLVE THE PROBLEM

The first embodiment of the present invention is a microchip substrate adhesion method in which a channel groove (namely, a groove for a flow channel) is formed in at least one of two resin members and the aforesaid two resin members are allowed to adhere to each other so that the surface, where the aforesaid channel groove is formed, is incorporated inside, and the aforesaid method is characterized in that an SiO₂ film, which incorporates SiO₂ as a major component, is formed on the adhering side surface of each of the aforesaid two resin members, and by activating the aforesaid SiO₂ film, both aforesaid resin members are allowed to adhere to each other.

Further, the second embodiment of the present invention is a microchip substrate adhesion method according to the first embodiment and is characterized in that the aforesaid activation is carried out via ultraviolet ray irradiation.

Further, the third embodiment of the present invention is a microchip substrate adhesion method according to the second embodiment and is **characterized in that** the wavelength of ultraviolet rays employed for the aforesaid ultraviolet ray irradiation is 170 nm - 180 nm.

Further, the fourth embodiment of the present invention is a microchip substrate adhesion method according to the first embodiment and is characterized in that the aforesaid activation is carried out via plasma irradiation.

Further, the fifth embodiment of the present invention is a microchip substrate adhesion method according to the first embodiment and is characterized in that the aforesaid activation is carried out via ion beam irradiation.

Further, the sixth embodiment of the present invention is a microchip substrate adhesion method according to any of the first to fifth embodiments and is **characterized in that** surface roughness Ra of the aforesaid SiO₂ film is Ra ≤ 2 nm.

Further, the seventh embodiment of the present invention is a microchip substrate adhesion method according to any of the first to sixth embodiments and is characterized in that surface roughness Ra of the surface, which is the surface of aforesaid two resin members, and on which the aforesaid SiO₂ film is formed, is Ra ≤ 2 nm.

Further, the eighth embodiment of the present invention is a microchip substrate adhesion method according to any of the first to fifth embodiments and is characterized in that, among the aforesaid two resin members, the resin member having thereon the aforesaid channel groove is a plate-like member and the resin member having thereon no aforesaid channel groove is a film-like member.

Further, the tenth embodiment of the present invention is the microchip which is prepared in such a manner that among two resin members, a channel groove is formed on at least one of the aforesaid resin members, and the aforesaid two resin members are allowed to adhere to each other so that the surface, on which the aforesaid channel grove is formed, is incorporated inside, and is characterized in that at least two SiO₂ films are formed between the aforesaid two resin members and the aforesaid two resin members are allowed to adhere to each other via the aforesaid at least two SiO₂ films.

Further, the eleventh embodiment of the present invention is the microchip according to the tenth embodiment and is characterized in that surface roughness Ra in the interface between the at least two SiO₂ films is Ra ≤ 2 nm.

Further, the twelfth embodiment of the present invention is the microchip of either the tenth or eleventh embodiment and is characterized in that surface roughness Ra of the surface of the resin member, and also the surface, on which the aforesaid SiO₂ films are formed, is Ra ≤ 2 nm.

Further, the thirteenth embodiment of the present invention is the microchip of any one of the tenth to twelfth embodiments and is characterized in that among the aforesaid two resin members, the resin member having thereon the aforesaid channel groove is the plate-like member and the resin member having thereon no aforesaid channel groove is the film-like member.

### EFFECT OF THE INVENTION

According to the present invention, it becomes possible to provide, without employing adhesive agents, a microchip in which a SiO₂ film is formed on the interior surface of a groove for a flow channel.

### BRIEF DESCRIPTION OF THE DRAWINGS

FIGS. 1a - 1c are a cross-sectional views of a microchip substrate to illustrate the adhesion method of the microchip substrate according to the first embodiment of the present invention.
FIGS. 2a - 2c are cross-sectional views of a microchip substrate to illustrate the adhesion method of the microchip substrate according to the second embodiment of the present invention.
FIGS. 3a - 3c are cross-sectional views to illustrate the adhesion method of the microchip substrate according to conventional technologies.

### DESCRIPTION OF THE NUMERALS

- 10, 20, and 30:: microchip substrates
- 11, 31, and 40:: minute channels
- 12, 13, 21, 22, 32, and 33:: SiO₂ films

### DESCRIPTION OF THE PREFERRED EMBODIMENTS

### (First Embodiment)

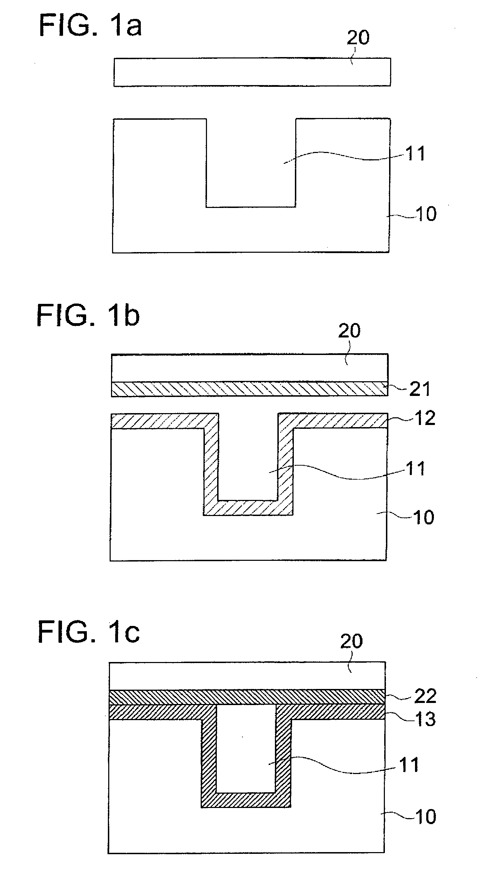

The adhesion method of the microchip substrates according to the first embodiment of the present invention, as well as the microchip produced by the aforesaid method will now be described with reference to FIGS. 1a - 1c. FIGS. 1a - 1c are cross-sectional views of the microchip substrates to illustrate the adhesion method of the microchip substrates according to the first embodiment of the present invention.

As shown in FIG. 1a, minute groove-like channel 11 is formed on the surface of microchip substrate 10. Microchip substrate 20, which is an opposed part for adhesion of microchip 10, is a plate-like substrate. By allowing microchip substrate 10 to adhere to microchip substrate 20 so that the surface, on which minute channel 11 is formed, is incorporated inside, microchip substrate 20 functions as a lid (a cover) of minute channel 11, whereby a microchip is produced. Further, microchip substrates 10 and 20 correspond to examples of the "resin member" of the present invention.

Resins are employed in microchip substrates 10 and 20. As desired characteristics for the aforesaid resins, listed are good moldability (transferability or mold release), high transparency, and low self-fluorescence to ultraviolet rays and visible light, however the aforesaid conditions are not specifically limited. Preferred examples thereof include polycarbonate, polymethyl methacrylate, polystyrene, polyacrylonitrile, polyvinyl chloride, polyethylene terephthalate, nylon 6, nylon 66, polyvinyl acetate, polyvinylidene chloride, polypropylene, polyisoprene, polyethylene, polydimethylsiloxane, and cyclic polyolefin. Of these, specifically preferred are polymethyl methacrylate and cyclic polyolefin. The same or different materials may be employed in microchips 10 and 20.

The shape of microchip substrates 10 and 20 is not specifically limited as long as it is easily handled and analyzed. For example, a square of about 10 mm - about 200 mm is preferred, but a square of 10 mm - 100 mm is more preferred. The shape of microchip substrates 10 and 20 may be matched to analytical methods and analytical instruments, and shapes such as a square form, a rectangular form, or a circular form are preferred.

A shape of minute channel 11 is preferred which enables reducing the amount of the used analytical samples and reagents. Further, in consideration of the production accuracy of molding dies, transferability, and mold release, the values of both width and depth are preferably in the range of 10 µm - 200 µm, however, the aforesaid values are not specifically limited. Further, the width and depth of minute channel 11 may be determined depending on the intended use of microchips. Further, in order to simplify the description, the shape of the cross-section of minute channel 11 is drawn to be rectangular in FIGS. 1a - 1c, which is just one example of minute channel 11, however, the shape of the cross-section may have a curved shape.

Further, in consideration of moldability, the plate thickness of microchip substrate 10, on which minute channel 11 is formed, is preferably about 0.2 mm - about 5 mm, but is more preferably 0.5 mm - 2 mm. In consideration of moldability, the thickness of microchip substrate 20, which functions as a lid (a cover) to cover minute channel 11 is preferably about 0.2 mm - about 5 mm, but is more preferably 0.5 mm - 2 mm. When the minute channel is not formed on microchip substrate 20 which functions as a lid (a cover), instead of a plate-like member, a film (a sheet-like member) may be employed. In such a case, the film thickness is preferably 30 µm - 300 µm, but is more preferably 50 µm - 150 µm.

Further, as shown in FIG. 1b, SiO₂ film 12 is formed on the surface of microchip substrate 10, while SiO₂ film 21 is formed on the surface of microchip substrate 20. With regard to microchip substrate 10 on which minute channel 11 is formed, SiO₂ film 12 is formed on the surface on which minute channel 11 is formed. At the same time, on the interior surface of minute channel 11, an SiO₂ film is formed, while an SiO₂ film is also formed on the surface (the adhesion surface) which is allowed to adhere to microchip substrate 20. SiO₂ films 12 and 21 are ones composed of SiO₂ as a major component, and impurities other than SiO₂ may be incorporated in an amount which maintains the hydrophilic function of the SiO₂ film.

### (SiO₂ Film Forming Method)

It is possible to form SiO₂ films 12 and 21 via vapor deposition, sputtering, CVD, or coating, but aforesaid film forming methods are not specifically limited. Further, with regard to SiO₂ film 12 and SiO₂ film 21, each of the forming methods may differ. Film forming methods via coating, sputtering, or CVD, are more preferred since it is possible to form an SiO₂ film which results in desired adhesion to the interior surface of minute channel 11, especially the vertical wall surface of minute channel 11.

### (SiO₂ Film Forming Example via Coating)

For instance, when SiO₂ films 12 and 21 are formed via coating, a coating solution, which forms an SiO₂ film after curing is applied onto the surface of microchip substrates 10 and 20, followed by curing the coating solution, whereby it is possible to form SiO₂ films 12 and 21 on the surface of microchip substrates 10 and 20.

As a coating solution, employed is, for example, a solution prepared by dissolving a polysiloxane oligomer prepared via hydrolysis and condensation polymerization of alkoxysilane in an alcohol solvent. In this case, the resulting coating solution is heated to volatilize the alcohol solvent, whereby an SiO₂ film is formed. Specifically listed are GLASSCA 7003, produced by JSR Corp. and METHYL SILICATE 51 produced by Colcoat Co., Ltd.

Further, perhydropolysilazane is dissolved in a xylene and dibutyl ether solution and the resulting solution is employed as a coating solution. In this case, the aforesaid coating solution is heated to volatilize the solvents and simultaneously, is allowed to react with water to form an SiO₂ film. Specifically listed is AQUAMICA, produced by AZ Electronic Materials Co.

Further, an inorganic-organic hybrid polymer which is prepared via hydrolysis and co-condensation of alkoxysilyl group-containing alkoxysilane is dissolved in an alcohol solvent, and the resulting solution is employed as a coating solution. In this case, the aforesaid solution is heated to volatilize the alcohol solvent, whereby a hybrid film composed of SiO₂ as a major component is formed. Specifically listed is GLASSCA 7506, produced by JSR Corp.

### (Coating Method of Coating Solution)

It is essential that a coating solution is uniformly applied onto microchip substrates 10 and 20. In consideration of physical properties (viscosity and volatility) of the coating solution, an appropriate coating method is selected. Examples thereof include dipping, spray coating, spin coating, slit coating, screen printing, pad printing, and ink-jet printing.

Further, by curing the coating solution, SiO₂ films 12 and 21 are formed. For instance, when a heat curable coating solution is employed, SiO₂ films 12 and 21 are formed by curing the coating solution via application of a heat treatment.

### (Curing Method of Coating Solution)

When an SiO₂ film is formed by curing a coating solution, it is preferable to form a solid network structure of SiO₂ via sufficient volatilization of the coating solution. In consideration of physical properties (viscosity, volatility, and catalysts), an appropriate curing method is selected. For example, a coating solution is cured while being allowed to stand at normal temperature, is cured by heating at a temperature of 60 °C - 100 °C, or is cured at high temperature and high humidity (such as a temperature of 60 °C and a humidity of 90%, or a temperature of 80 °C and a humidity of 90%). Further, a coating solution may be cured utilizing ultraviolet ray curing or visible light curing.

### (Example of SiO₂ Film Formation via Sputtering)

Further, when SiO₂ films 12 and 21 are formed via sputtering, SiO₂ films 12 and 21 are formed employing, for example, the sputtering apparatus (apparatus name: RAS-1100C), produced by Shincron Co., Ltd. The apparatus is divided into a silicon metal film forming chamber and an oxidation chamber, and SiO₂ films 12 and 21 are formed by rotating a drum to which a base material is allowed to adhere. For example, 200 nm SiO₂ films 12 and 21 were formed under conditions of an argon gas flow rate of 250 sccm, an oxygen gas flow rate of 120 sccm, an RF output of 4.5 kW, and a film forming rate of 4 Å/second.

### (Example of SiO₂ Film Formation via CVD)

Further, when SiO₂ films 12 and 21 are formed via CVD, SiO₂ films 12 and 21 are formed, for example, by employing the CVD apparatus (apparatus name: PD-270ST), produced by SAMCO, Inc. A liquid source incorporating silicon such as TEOS (Tetra Ethoxy Silane) and TMOS (Tetra Methoxy Silane) is vaporized, and SiO₂ films 12 and 21 are formed via decomposition and oxidation in a plasma space. For example, 200 nm SiO₂ films 12 and 21 are formed under conditions of a TEOS flow rate of 12 sccm, an oxygen gas flow rate of 400 sccm, an RF output of 300 W, a pressure of 50 Pa, and a film forming rate of 30 Å/second.

### (Thickness of SiO₂ Film)

Thickness of SiO₂ films 12 and 21 is determined while considering that all the interior surfaces of minute channel 11 is covered with SiO₂, adhesion to minute channel 11 can be ensured, and minute channel 11 is not blocked. When the SiO₂ film is formed via coating, the thickness is regulated depending on the characteristics and kinds of coating solution. The thickness is preferably in the range of a value of 10 nm - 3 µm, but is more preferably in the range of a value of 10 nm - 2 µm. Further, in the case of formation of the SiO₂ film via sputtering or CVD, when an accurate SiO₂ film is formed, internal stress of the SiO₂ film tends to increase, so that a value in the range of 10 nm - 1 µm is preferred, but a value in the range of 10 nm - 200 nm is more preferred.

### (Surface Roughness of SiO₂ Film)

As described in the present embodiment, when microchip substrate 10 and microchip substrate 20 are allowed to adhere to each other via an SiO₂ film without employing adhesive agents, the surface state of the SiO₂ film significantly affects adhesion strength, whereby surface roughness Ra (described in JIS B0601) of the SiO₂ film becomes important. In order to allow the bonding bond of the OH group formed on the surface of the SiO₂ film to result in bonding at a molecular level, it is preferable that the contact surface between the substrates is flat and the contact area is greater.

For instance, when the surface roughness Ra of SiO₂ films 12 and 21 was Ra ≤ 2 nm, it was confirmed that neither liquid leakage nor substrate peeling occurred via liquid feeding under pressure into the interior of minute channel 11 and electrophoresis. Accordingly, surface roughness Ra of SiO₂ films 12 and 21 is preferably Ra ≤ 2 nm, but is more preferably Ra ≤ 1 nm.

Further, flatness is important in terms of an increase in the contact area, not in the nano order but in the micron order. When a resin microchip substrate is formed, cases occur in which it is difficult to ensure flatness near holes and grooves. In that case, even though it is impossible to realize the desired flatness of the microchip substrate on which the minute channel has been formed, it is possible to ensure desired adhesion between the substrates by employing a plate-like member as a microchip substrate on which the minute channel has been formed and a film as a microchip substrate on which no minute channel is formed.

Further, when an SiO₂ film is formed on a homogeneous surface of a microchip substrate, the surface roughness of the resulting SiO₂ film becomes nearly equal to the surface roughness of the microchip substrate. When the SiO₂ film is formed via vapor deposition, sputtering, or CVD, the above tendency is enhanced. Accordingly, when it is intended to lower the surface roughness of the SiO₂ film, even in the case of employing a plate-like member, or a film, it is desired to lower the surface roughness of the resulting microchip substrate. For example, roughness Ra of the microchip surface on which an SiO₂ film is to be formed is preferably Ra ≤ 2 nm, but is more preferably Ra ≤ 1 nm. As noted above, when it is difficult to reduce the surface roughness of the microchip substrate, an SiO₂ film which is slightly thicker (for example, at least 1 µm) is formed, whereby it is possible to realize a ultra-accurate surface (Ra ≤ 1 nm) via a lapping process, mirror finishing, and a CMP process.

Further, the surface of the SiO₂ film is activated, and thereafter, as shown in FIG. 1c, microchip substrate 10 and microchip 20 are overlapped in such a manner that the SiO₂ film formed surface is inside. By doing so, it is possible to allow microchip substrate 10 to adhere to microchip substrate 20 via surface activated SiO₂ films 13 and 22, whereby a microchip is produced. Between microchip substrate 10 and microchip substrate 20, two SiO₂ films 13 and 22 exist and no materials such as adhesive agents, which have been conventionally employed, exist.

### (Activation Method)

"Activation", as described herein, means that atoms and molecules absorb energy such as light and heat, and are converted to a higher energy state. Activation of SiO₂ films 12 and 21 in the present embodiment means that organic compounds adhered to the surfce of SiO₂ films 12 and 21 are decomposed and removed via exposure to high energy such as light and heat, and by doing so, a bonding bond of the OH group is formed on the surface of SiO₂ films 12 and 21, whereby a state, which tends to undergo chemical reactions, is formed. Activation means of SiO₂ films 12 and 21 include ultraviolet ray irradiation, plasma irradiation, ion beam irradiation, ultrasonic wave washing, acid alkali washing, and heating, however the means are not specifically limited. In the present invention, as an activation example, detailed are ultraviolet ray irradiation, ion exposure, and plasma irradiation.

### (Example of Ultraviolet Ray Irradiation)

When SiO₂ films 12 and 21 are activated via ultraviolet ray irradiation, it is preferable that SiO₂ films 12 and 21 are irradiated with ultraviolet rays of a wavelength of 170 nm - 180 nm to activate. For example, the excimer light irradiation unit (Type UER20-172C), produced by USHIO Inc., is employed under conditions of a wavelength of 172 nm and a radiation intensity of 10 mW/cm², and the surface of SiO₂ films 12 and 21 is activated. By irradiating the surface of SiO₂ films 12 and 21 with excimer light, a minute amount of organic compounds is decomposed and removed. Further, via direct action of the excimer light to oxygen which exists in the space, active oxygen species, such as excited oxygen atoms or ozone, are generated at a high concentration to decompose and remove a minute amount of organic compounds, whereby an OH bonding bond is generated to activate the surface of SiO₂ films 12 and 21.

For example, since light energy of the excimer light at a wavelength of 172 nm is 166.6 kcal/mol, which is higher than almost all the molecular bond energy, it is effective for the surface activation of SiO₂ films 12 and 21.

### (Example of Ion Irradiation)

Further, when SiO₂ films 12 and 21 are activated via ion irradiation, the surface of SiO₂ films 12 and 21 is activated via ion irradiation under conditions of an oxygen gas flow rate of 50 sccm, an argon gas flow rate of 8 sccm, a beam voltage of 500 V, a beam electric current of 400 mA, and a vacuum of 1.5 x 10⁻² Pa, employing, for example, RF ION SOURCE (Type OIS-two), produced by OPTORUN Co., Ltd. By carrying out the oxygen ion and argon ion irradiation on the surface of SiO₂ films 12 and 21, a minute amount of organic compounds is decomposed and removed, and the bonding bond of the OH group is generated to activate the surface of SiO₂ films 12 and 21.

### (Example of Plasma Irradiation)

Further, when SiO₂ films 12 and 21 are activated via plasma irradiation, the surface of SiO₂ films 12 and 21 is activated via aforesaid plasma irradiation under conditions of an oxygen gas flow rate of 200 sccm, an RF output of 400 W, and a vacuum of 50 Pa, employing, for example, PLASMA DRY CLEANER (Type PC-1000), produced by SAMCO, Inc. By carrying out the plasma irradiation on the surface of SiO₂ films 12 and 21, a minute amount of organic compounds is decomposed and removed, and the bonding bond of the OH group is generated to activate the surface of SiO₂ films 12 and 21. In plasma, exist gases, electrons, excited spices, ions, and radicals, which affect the surface of SiO₂ films 12 and 21, to result in activation.

As described above, SiO₂ films 12 and 21 are formed on the adhesion surface of microchip substrates 10 and 20. After superposing microchip substrates 10 and 20, SiO₂ films 12 and 21 are activated, whereby it becomes possible to allow microchip substrate 10 to adhere to microchip substrate 20 without employing adhesive agents, which may deteriorate the hydrophilic function. Further, since an SiO₂ film is formed on the interior surface of minute channel 11, it becomes possible to result in a hydrophilic function on the interior surface of minute channel 11.

Since the SiO₂ film exhibits a hydrophilic function, it becomes possible to retard adhesion of low- and high-molecular compounds such as proteins onto the interior surface of minute channel 11. Since microchip substrates 10 and 20 are composed of resins, they are commonly hydrophobic and low- and high-molecular compounds such as proteins tend to adhere to minute channel 11. However, by forming the SiO₂ film, it becomes possible to retard the aforesaid adhesion.

Further, since the SiO₂ film is chemically stable, it is possible to stably maintain the hydrophilic function. It is possible to achieve hydrophilicity by applying a plasma process to the surface of resin microchip substrates 10 and 20. However, the resulting effect decreases over an elapse of time, and in many cases, the resulting hydrophilic function is lost over several days. Further, it is possible to achieve hydrophilicity via surface modification in such a manner that the surface of microchip substrates 10 and 20 are subjected to dipping of polymers such as oligoethylene glycol or 2-methacryroyloxyethylphosphorylcoline. Occasionally, a uniform hydrophilic surface is not achieved due to causes such as a low adhesion force of a surface modifying group and generation of unevenness.

Correspondingly, by forming microchip substrate 10 having thereon an SiO₂ film, on which minute channel 11 has been formed, and microchip substrate 20 which functions as a lid (a cover), even in cases when resin materials of microchip substrate 10 and microchip substrate 20 differ, it is possible to result in the same surface state. Thus, it is possible to enhance analysis accuracy and reliability. When the surface state of the substrates differs, the flow rate of liquid to be analyzed and reactions results in fluctuation, whereby problems occur in which the detection sensitivity of the analysis chip is lowered. By forming the SiO₂ film on the interior surface of minute channel 11, it is possible to retard generation of fluctuation and to enhance detection sensitivity of the analysis chip.

### (Second Embodiment)

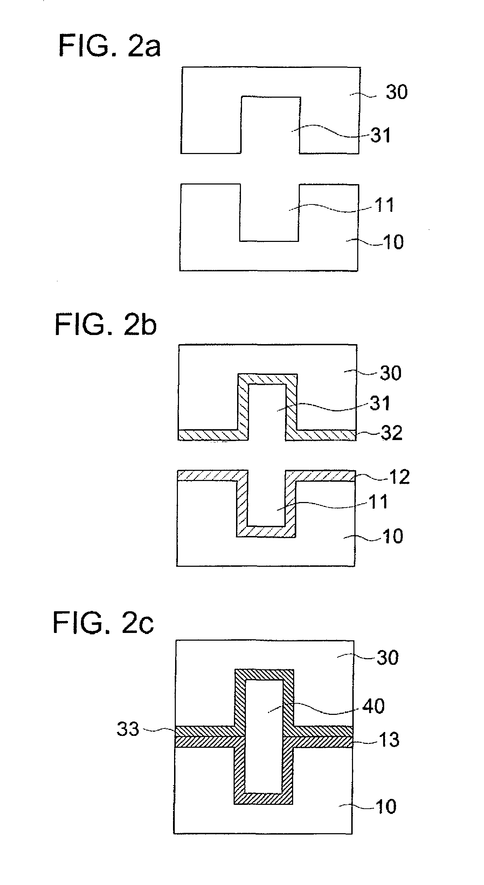

The adhesion method of microchip substrates according to the second embodiment of the present invention, as well as the microchip produced by the aforesaid method, will now be described with reference to FIG. 2. FIG. 2 is a cross-sectional view of the microchip substrate to illustrate the adhesion method of the microchip substrates according to the second embodiment of the present invention. In the aforesaid first embodiment, the minute channel is formed only on one of them, while in the second embodiment, the minute channel is formed on both microchip substrates.

As shown in FIG. 2a, prepared are microchip substrate 10 on which surface minute channel 11 is formed and microchip substrate 30 on which minute channel 31 is formed. By allowing microchip substrate 10 to adhere to microchip substrate 30 so that minute channels 11 and 31 are inside, a deeper minute channel is formed.

Subsequently, as shown in FIG. 2b, SiO₂ film 12 is formed on the surface of microchip substrate 10, while SiO₂ film 32 is formed on the surface of microchip substrate 30. In both substrates, SiO₂ films 12 and 32 are formed on the surface on which minute channels 11 and 31 are formed. At the same time, the SiO₂ film is formed on the interior surface of minute channels 11 and 31, and SiO₂ films 12 and 32 are formed on the surface (the adhesion surfce) which is adhered to the corresponding substrate.

In the same manner as in the first embodiment, it is possible to form SiO₂ films 12 and 32 via vapor deposition, sputtering, CVD, or coating. Further, thickness and surface roughness Ra are identical to those of the first embodiment.

Further, the surface of the SiO₂ film is activated in the same manner as in the first embodiment, and thereafter, as shown in FIG. 2c, microchip substrate 10 and microchip substrate 30 are superposed so that the surface on which the SiO₂ film has been formed is inside. At that time, the positional adjustment of minute channels 11 and 31 is carried out so that minute channel 11 and minute channel 31 are superposed accurately. By doing so, it is possible to allow microchip substrate 10 to adhere to microchip substrate 30 via surface activated SiO₂ films 13 and 33, whereby a microchip is produced. Via the aforesaid adhesion, it is possible to form minute channel 40 which exhibits a relatively large aspect ratio. Between microchip substrate 10 and microchip substrate 30, exist only SiO₂ films 13 and 33, whereby no compounds exist such as adhesive agents, which have been employed.

Methods to activate the SiO₂ film are identical to those in the first embodiment, and it is possible to activate the SiO₂ film via ultraviolet ray irradiation, plasma irradiation, ion beam irradiation, ultrasonic wave washing, acid alkali washing, or heating.

As noted above, it becomes possible to allow microchip substrate 10 to adhere to microchip substrate 30 without employing adhesive agents, which may retard the hydrophilic function, in such a manner that SiO₂ films 12 and 32 are formed on the adhesion surface of microchip substrates 10 and 30, and after superposing microchip substrates 10 and 30, SiO₂ films 12 and 32 are activated. Further, since the SiO₂ film is formed on the interior surfaces of minute channels 11 and 31, it becomes possible to result in a hydrophilic function on the interior surface of minute channel 40.

### Examples

Specific examples will now be described.

### (Example 1)

### (Microchip Substrate)

By molding a cyclic polyolefin resin (ZEONOA, produced by ZEON Corp.), which is a transparent resin material, via an injection molding machine, a channel side microchip substrate was prepared which was composed of a plate-like member of an external dimension of 50 mm x 50 mm x 1 mm having a plurality of minute channels at a width of 50 µm and a depth of 50 µm, and a plurality of through-holes at an inner diameter of 2 mm. The resulting channel side microchip substrate corresponds to microchip substrate 10 on which minute channel 11 is formed in the aforesaid first embodiment. Further, employed, as a cover side microchip substrate, was the transparent resin film (ZEONOA FILM, produced by ZEON Corp.) which was cut at the same dimensions as the channel side microchip substrate. The film thickness was 100 µm. The resulting film-like cover side microchip substrate corresponds to microchip substrate 20 which functions as a lid (a cover) in the first embodiment.

### (Formation of SiO₂ Film)

In Example 1, the SiO₂ film was formed via CVD. On the adhesion surface of the aforesaid channel side microchip substrate and cover side microchip substrate, an SiO₂ film was formed by employing the CVD apparatus (apparatus name: PD-270ST), produced by SAMCO, Inc. On the adhesion surface of the channel side microchip substrate and the cover side microchip substrate, 200 nm SiO₂ films were formed under conditions of a TEOS flow rate of 12 sccm, an oxygen gas flow rate of 400 sccm, an RF output of 300 W, a pressure of 50 Pa, and a film forming rate of 30 Å/second. By employing the CVD film forming apparatus, it was possible to uniformly form an SiO₂ film on the interior surface of the minute channel at a width of 50 µm and a depth of 50 µm. Further, the thickness of the SiO₂ film in the minute channel was 130 nm.

### (Adhesion)

In example 1, the SiO₂ film was activated by ultraviolet ray irradiation. By employing the excimer light exposure unit (Type UER20-172C), produced by USHIO Inc., SiO₂ film was irradiated with ultraviolet rays for 30 minutes under conditions of a wavelength of 172 nm and a radiation intensity of 10 mW/cm², and the SiO₂ film of the channel side microchip substrate and the cover side microchip substrate was activated. Thereafter, the channel side microchip substrate and the cover side microchip substrate were brought into pressure contact at a force of 0.2 kgf/cm² and resulted in adhesion within one minute, while the minute channels were inside, so that the active state of the surface was not lost, whereby a microchip was produced.

### (Evaluation)

The aforesaid microchip was connected to a syringe pump and water was applied under pressure. No liquid leak was noted from the minute channels and sufficient sealing properties were exhibited. Further, desired wettability to water was exhibited and desired hydrophilicity was also exhibited. Liquid feeding pressure was set at 13 MPa.

### (Example 2)

### (Microchip Substrate)

By molding the cyclic polyolefin resin (ZEONOA, produced by ZEON Corp.), which was a transparent resin material, via an injection molding machine, a channel side microchip substrate was prepared which was composed of a plate-like member of an external dimension of 50 mm x 50 mm x 1 mm having a plurality of minute channels at a width of 50 µm and a depth of 50 mm, and a plurality of through-holes at an inner diameter of 2 mm. The resulting channel side microchip substrate corresponds to microchip substrate 10 on which minute channel 11 is formed in the aforesaid first embodiment. Further, employed as a cover side microchip substrate, the transparent resin film (ZEONOA FILM, produced by ZEON Corp.) which was cut at the same dimensions as the channel side microchip substrate. The film thickness was 100 µm. The resulting film-like cover side microchip substrate corresponds to microchip substrate 20 which functions as a lid (a cover) in the first embodiment.

### (Formation of SiO₂ Film)

In Example 1, the SiO₂ film was formed via CVD. On the adhesion surface of the aforesaid channel side microchip substrate and cover side microchip substrate, an SiO₂ film was formed by employing the CVD apparatus (apparatus name: PD-270ST), produced by SAMCO, Inc. On the adhesion surface of the channel side microchip substrate and cover side microchip substrate, a 200 nm SiO₂ film was formed under conditions of a TEOS flow rate of 12 sccm, an oxygen gas flow rate of 400 sccm, an RF output of 300 W, a pressure of 50 Pa, and a film forming rate of 30 Å/second. By employing the CVD film forming apparatus, it was possible to uniformly form an SiO₂ film on the interior surface of the minute channel at a width of 50 µm and a depth of 50 µm. Further, the thickness of the SiO₂ film in the minute channel was 130 nm.

### (Adhesion)

In Example 2, the SiO₂ film was activated via ion exposure. By employing RF ION SOURCE (Type OIS-two), produced by OPTORUN Co., Ltd., ion exposure was carried out for 30 seconds onto the SiO₂ film under conditions of an oxygen flow rate of 50 sccm, an argon gas flow rate of 8 sccm, a beam voltage of 500 V, a beam current of 400 mA, and a vacuum of 1.5 x 10⁻² Pa, and the SiO₂ film of the channel side microchip substrate and cover side microchip substrate was activated. Thereafter, the channel side microchip substrate and the cover side microchip substrate were brought into pressure contact at a force of 0.2 kgf/cm² and resulted in adhesion, while the minute channels were incorporated inside, within 5 minute after being open to atmosphere, so that the active state of the surface was not lost, whereby a microchip was produced. Further, in Example 2, the substrates were brought into pressure contact with each other in a state of being open to atmosphere. However, when after exposure to ion beams, the pressure contact is carried out under vacuum without being open to atmosphere, it is possible to achieve stronger adhesion of the substrates.

### (Evaluation)

The aforesaid microchip was connected to a syringe pump and water was applied under pressure. No liquid leak was noted from the minute channels and sufficient sealing properties were exhibited. Further, desired wettability to water was exhibited and desired hydrophilicity was also exhibited. Liquid feeding pressure was set at 13 MPa.

### (Example 3)

### (Microchip Substrate)

By molding the cyclic polyolefin resin (ZEONOA, produced by ZEON Corp.), which was a transparent resin material, via an injection molding machine, a channel side microchip substrate was prepared which was composed of a plate-like member of an external dimension of 50 mm x 50 mm x 1 mm having a plurality of minute channels at a width of 50 µm and a depth of 50 µm, and a plurality of through-holes at an inner diameter of 2 mm. The resulting channel side microchip substrate corresponds to microchip substrate 10 on which minute channel 11 is formed in the aforesaid first embodiment. Further, employed as a cover side microchip substrate, the transparent resin film (ZEONOA FILM, produced by ZEON Corp.) which was cut at the same dimensions as the channel side microchip substrate. The film thickness was 100 µm. The resulting film-like cover side microchip substrate corresponds to microchip substrate 20 which functions as a lid (a cover) in the first embodiment.

### (Formation of SiO₂ Film)

In Example 3, the SiO₂ film was formed via CVD. On the adhesion surface of the aforesaid channel side microchip substrate and cover side microchip substrate, an SiO₂ film was formed by employing the CVD apparatus (apparatus name: PD-270ST), produced by SAMCO, Inc. On the adhesion surface of the channel side microchip substrate and cover side microchip substrate, 200 nm SiO₂ films were formed under conditions of a TEOS flow rate of 12 sccm, an oxygen gas flow rate of 400 sccm, an RF output of 300 W, a pressure of 50 Pa, and a film forming rate of 30 Å/second. By employing the CVD film forming apparatus, it was possible to uniformly form an SiO₂ film on the interior surface of the minute channel at a width of 50 µm and a depth of 50 µm. Further, the thickness of the SiO₂ film in the minute channel was 130 nm.

### (Adhesion)

In Example 3, the SiO₂ film was activated via plasma irradiation. By employing PLASMA DRY CLEANER (Type PC-1000), produced by SAMCO, Inc., the SiO₂ film was irradiated with plasma for 5 minutes under conditions of an oxygen flow rate of 200 sccm, an RF output of 400 W, and a vacuum of 50 Pa, and the SiO₂ film of the channel side microchip substrate and cover side microchip substrate was activated. Thereafter, the channel side microchip substrate and the cover side microchip substrate were brought into pressure contact at a force of 0.2 kgf/cm² and resulted in adhesion, while the minute channels were incorporated inside, within 5 minute after being open to atmosphere so that the active state of the surface was not lost, whereby a microchip was produced. In Example 3, the substrates were brought into pressure contact with each other in a state of being open to atmosphere. However, when a pressure contact is carried out under vacuum after plasma irradiation, without being open to atmosphere, it is possible to achieve stronger adhesion of the substrates.

### (Evaluation)

The aforesaid microchip was connected to a syringe pump and water was applied under pressure. No liquid leak was noted from the minute channels and sufficient sealing properties were exhibited. Further, desired wettability to water was exhibited and desired hydrophilicity was also exhibited. Further, liquid feeding pressure was set at 13 MPa.

### (Example 4)

### (Microchip Substrate)

By molding a methyl polymethacrylate resin (ACRYPET VH, produced by Mitsubishi Rayon Co., Ltd.), which was a transparent resin material, via an injection molding machine, a channel side microchip substrate was prepared which was composed of a plate-like member of an external dimension of 50 mm x 50 mm x 1 mm having a plurality of minute channels at a width of 50 µm and a depth of 50 µm, and a plurality of through-holes at an inner diameter of 2 mm. The resulting channel side microchip substrate corresponds to microchip substrate 10 on which minute channel 11 is formed in the aforesaid first embodiment. Further, employed as a cover side microchip substrate, a transparent resin film (ACRYPLANE FILM, produced by Mitsubishi Rayon Co., Ltd.) which was cut into the same dimensions as the channel side microchip substrate. The film thickness was 100 µm. The resulting film-like cover side microchip substrate corresponds to microchip substrate 20 which functions as a lid (a cover) in the first embodiment.

### (Formation of SiO₂ Film)

In Example 4, the SiO₂ film was formed via CVD. On the adhesion surface of the aforesaid channel side microchip substrate and cover side microchip substrate, an SiO₂ film was formed by employing the CVD apparatus (apparatus name: PD-270ST), produced by SAMCO, Inc. On the adhesion surface of the channel side microchip substrate and cover side microchip substrate, 1,000 nm SiO₂ films were formed under conditions of a TEOS flow rate of 12 sccm, an oxygen gas flow rate of 400 sccm, an RF output of 300 W, a pressure of 50 Pa, and a film forming rate of 30 Å/second. By employing the CVD film forming apparatus, it was possible to uniformly form an SiO₂ film on the interior surface of the minute channel at a width of 50 µm and a depth of 50 µm. Further, the thickness of the SiO₂ film in the minute channel was 700 nm. Since surface roughness Ra of the SiO₂ film was Ra ≤ 20 nm, the surface of the SiO₂ film was polished employing a CMP apparatus until Ra ≤ 1 nm was achieved.

### (Adhesion)

In Example 4, the SiO₂ film was activated via ion exposure. By employing RF ION SOURCE (Type OIS-two), produced by OPTORUN Co., Ltd., the SiO₂ film was irradiated with ion beams for 30 seconds under conditions of an oxygen flow rate of 50 sccm, an argon gas flow rate of 8 sccm, a beam voltage of 500 V, a beam electric current of 400 mA, and a vacuum of 1.5 x 10⁻² Pa, and the SiO₂ films of the channel side microchip substrate and cover side microchip substrate were activated. Thereafter, the channel side microchip substrate and the cover side microchip substrate were brought into pressure contact at a force of 0.2 kgf/cm² and resulted in adhesion, while the minute channels were incorporated inside, within 5 minute after being open to atmosphere so that the active state of the surface was not lost, whereby a microchip was produced. Further, in Example 4, the substrates were brought into pressure contact with each other in a state of being open to atmosphere. However, when the pressure contact is carried out under vacuum after ion beam exposure, without being open to atmosphere, it is possible to achieve stronger adhesion of the substrates.

### (Evaluation)

The aforesaid microchip was connected to a syringe pump and water was applied under pressure. No liquid leak was noted from the minute channels and sufficient sealing properties were exhibited. Further, desired wettability to water was exhibited and desired hydrophilicity was also exhibited. Further, liquid feeding pressure was set at 13 MPa.

As noted above, according to Examples 1 - 4, it is possible to produce a microchip in which the SiO₂ film is formed in the interior surface of the minute channel, in such a manner that the SiO₂ film is formed on the surface of a resin microchip substrate on which a minute channel is formed and by activating the resulting SiO₂ film, microchip substrates are allowed to adhere to each other without employing adhesive agents. Further, the microchip substrate materials and SiO₂ film forming methods, described in Examples 1 - 4, are examples, and the present invention is not limited thereto.

## Claims

1. A method of adhering microchip substrates comprising two resin members (10,30),
at least one of the resin members (10) having a channel groove, and
the resin members (10, 30) being adhered to each other so that a surface having thereon the channel groove (11) stays inside, wherein
the method comprising the steps of:
forming a SiO₂ film (12, 32) comprising SiO₂ as a major component on an adhering side surface of each resin member (10, 30);
activating the SiO₂ films (12, 32); and
adhering the resin members (10,30);
wherein the step of activating comprises an exposure to high energy or an acid alkali washing.

2. The method of claim 1, wherein the activating comprises ultraviolet ray irradiation, plasma irradiation, ion beam irradiation, ultrasonic wave washing, acid alkali washing, and heating.

3. The method of claim 1, wherein the activating step is carried out by irradiating the SiO₂ films (12, 32) with an ultraviolet ray.

4. The method of claim 3, wherein the wavelength of the ultraviolet ray is 170 nm - 180 nm.

5. The method of claim 1, wherein the activating step is carried out by irradiating the SiO₂ films (12, 32) with a plasma.

6. The method of claim 1, wherein the activating step is carried out by irradiating the SiO₂ films (12, 32) with an ion beam.

7. The method of any one of claims 1 - 6, wherein a surface roughness Ra of the SiO₂ films (12, 32) is Ra ≤ 2 nm.

8. The method of any one of claims 1 - 7, wherein a surface roughness Ra of surfaces of the resin members (10, 30) where the SiO₂ film (12, 32) is formed is Ra ≤ 2 nm.

9. The method of any one of claims 1 - 8, wherein a resin member (10) having the channel groove (11) is plate-like and a resin member (32) not having the channel groove is film-like.

10. A microchip comprising two resin members (10, 30), at least one of the resin members (10) having a channel groove (11) for a flow channel, wherein
the resin members (10, 30) are adhered to each other so that a surface having thereon the channel groove (11) stays inside,
wherein
at least two SiO₂ films (12, 32) are formed between the two resin members (10, 30) to adhere the two resin members (10, 30) via the at least two SiO₂ films (12, 32).

11. The microchip of claim 10, wherein a surface roughness Ra of the interface between the two or more SiO₂ films (12, 32) is Ra ≤ 2 nm.

12. The microchip of claim 10 or 11, wherein a surface roughness Ra of surfaces of the resin members (10, 32) where the SiO₂ films are formed is Ra ≤ 2 nm.

13. The microchip of any one of claims 10 - 12, wherein a resin member (10) having the channel groove (11) is plate-like and a resin member (30) not having the channel groove is film-like.

## Patentansprüche

1. Verfahren zum Kleben von Mikrochip-Substraten mit zwei Harzelementen (10, 30), wobei
zumindest eines der Harzelemente (10) eine Kanalkerbe aufweist, und
die Harzelemente (10, 30) aneinander geklebt sind, so dass eine Oberfläche mit der Kanalkerbe (11) darauf innen liegt, wobei
das Verfahren die folgenden Schritte aufweist:
Ausbilden eines SiO₂-Films (12, 32) mit SiO₂ als eine Hauptkomponente auf einer klebenden Seitenoberfläche jedes Harzelements (10, 30);
Aktivieren der SiO₂-Filme (12, 32); und
Kleben der Harzelemente (10, 30);
wobei der Schritt zum Aktivieren ein Aussetzen einer hohen Energie oder einer Säure-Alkali-Wäsche aufweist.

2. Verfahren nach Anspruch 1, wobei das Aktivieren eine Ultravioletter-Strahl-Bestrahlung, eine Plasma-Bestrahlung, eine Ionenstrahl-Bestrahlung, eine Ultraschallwellen-Wäsche, eine Säure-Alkali-Wäsche, und ein Erhitzen aufweist.

3. Verfahren nach Anspruch 1, wobei der Aktivierungsschritt durch Bestrahlen der SiO₂-Filme (12, 32) mit einem ultravioletten Strahl ausgeführt wird.

4. Verfahren nach Anspruch 3, wobei die Wellenlänge des ultravioletten Strahls 170 nm - 180 nm beträgt.

5. Verfahren nach Anspruch 1, wobei der Aktivierungsschritt durch Bestrahlen der SiO₂-Filme (12, 32) mit einem Plasma ausgeführt wird.

6. Verfahren nach Anspruch 1, wobei der Aktivierungsschritt durch Bestrahlen der SiO₂-Filme (12, 32) mit einem Ionenstrahl ausgeführt wird.

7. Verfahren nach einem der Ansprüche 1-6, wobei eine Oberflächenrauigkeit Ra der SiO₂-Filme (12, 32) Ra ≤ 2 nm beträgt.

8. Verfahren nach einem der Ansprüche 1-7, wobei eine Oberflächenrauigkeit Ra von Oberflächen der Harzelemente (10, 30), in denen die SiO₂-Filme (12, 32) ausgebildet sind, Ra ≤ 2 nm beträgt.

9. Verfahren nach einem der Ansprüche 1-8, wobei ein Harzelement (10) mit der Kanalkerbe (11) plattenartig ist, und ein Harzelement (32) ohne die Kanalkerbe filmartig ist.

10. Mikrochip mit zwei Harzelementen (10, 30), wobei zumindest eines der Harzelemente (10) eine Kanalkerbe (11) für einen Flusskanal aufweist, wobei
die Harzelemente (10, 30) aneinander geklebt sind, so dass eine Oberfläche mit der Kanalkerbe (11) darauf innen liegt,
wobei
zumindest zwei SiO₂-Filme (12, 32) zwischen den beiden Harzelementen (10, 30) ausgebildet sind, um die beiden Harzelemente (10, 30) über die zumindest zwei SiO₂-Filme (12, 32) zu kleben.

11. Mikrochip nach Anspruch 10, wobei eine Oberflächenrauigkeit Ra der Schnittfläche zwischen den beiden oder mehreren SiO₂-Filmen (12, 32) Ra ≤ 2 nm beträgt.

12. Mikrochip nach Anspruch 10 oder 11, wobei eine Oberflächenrauigkeit Ra von Oberflächen der Harzelemente (10, 32), in denen die SiO₂-Filme ausgebildet sind, Ra ≤ 2 nm beträgt.

13. Mikrochip nach einem der Ansprüche 10-12, wobei ein Harzelement (10) mit der Kanalkerbe (11) plattenartig ist, und ein Harzelement (30) ohne die Kanalkerbe filmartig ist.

## Revendications

1. Procédé pour réaliser l'adhérence de substrats de micropuce comprenant deux organes en résine (10, 30),
au moins l'un des organes en résine (10) comportant une rainure canal, et
les organes en résine (10, 30) étant adhérés l'un à l'autre de sorte qu'une surface sur laquelle se trouve la rainure canal (11) reste à l'intérieur, dans lequel
le procédé comprend les étapes de :
formation d'un film de SiO₂ (12, 32) comprenant du SiO₂ en tant que composant principal sur une surface côté adhérence de chaque organe en résine (10, 30) ;
activation des films de SiO₂ (12, 32) ; et
réalisation de l'adhérence des organes en résine (10, 30) ;
dans lequel l'étape d'activation comprend une exposition à un lavage alcalin acide ou à haute énergie.

2. Procédé selon la revendication 1, dans lequel l'activation comprend une irradiation aux rayons ultraviolets, une irradiation par plasma, une irradiation par faisceaux d'ions, un lavage aux ondes ultrasoniques, un lavage alcalin acide et un chauffage.

3. Procédé selon la revendication 1, dans lequel l'étape d'activation est réalisée en irradiant les films de SiO₂ (12, 32) avec un rayon ultraviolet.

4. Procédé selon la revendication 3, dans lequel la longueur d'onde du rayon ultraviolet est de 170 nm à 180 nm.

5. Procédé selon la revendication 1, dans lequel l'étape d'activation est réalisée en irradiant les films de SiO₂ (12, 32) avec un plasma.

6. Procédé selon la revendication 1, dans lequel l'étape d'activation est réalisée en irradiant les films de SiO₂ (12, 32) avec un faisceau d'ions.

7. Procédé selon l'une quelconque des revendications 1 à 6, dans lequel une rugosité de surface Ra des films de SiO₂ (12, 32) est Ra ≤ 2 nm.

8. Procédé selon l'une quelconque des revendications 1 à 7, dans lequel une rugosité de surface Ra des surfaces des organes en résine (10, 30) où est formé le film de SiO₂ (12, 32) est Ra ≤ 2 nm.

9. Procédé selon l'une quelconque des revendications 1 à 8, dans lequel un organe en résine (10) comportant la rainure canal (11) est de type plaque et un organe en résine (32) ne comportant pas la rainure canal est de type film.

10. Micropuce comprenant deux organes en résine (10, 30), au moins l'un des organes en résine (10) comportant une rainure canal (11) pour un canal d'écoulement, dans laquelle
on fait adhérer les organes en résine (10, 30) l'un à l'autre de sorte qu'une surface sur laquelle se trouve la rainure canal (11) reste à l'intérieur,
dans laquelle
au moins deux films de SiO₂ (12, 32) sont formés entre les deux organes en résine (10, 30) pour faire adhérer les deux organes en résine (10, 30) via les au moins deux films de SiO₂ (12, 32).

11. Micropuce selon la revendication 10, dans laquelle une rugosité de surface Ra de l'interface entre les deux films de SiO₂ (12, 32) ou plus est Ra ≤ 2 nm.

12. Micropuce selon la revendication 10 ou 11, dans laquelle une rugosité de surface Ra des surfaces des organes en résine (10, 30) où sont formés les films de SiO₂ est Ra ≤ 2 nm.

13. Micropuce selon l'une quelconque des revendications 10 à 12, dans laquelle un organe en résine (10) comportant la rainure canal (11) est de type plaque et un organe en résine (30) ne comportant pas la rainure canal est de type film.
